Europäisches Patentamt

European Patent Office

Office européen des brevets

(11) Publication number: **0 655 782 A2**

# EUROPEAN PATENT APPLICATION

(21) Application number: 94118690.0

(51) Int. Cl.6: **H01L 23/495**

(22) Date of filing: 28.11.94

(30) Priority: **29.11.93 JP 320842/93**

(43) Date of publication of application:
**31.05.95 Bulletin 95/22**

(84) Designated Contracting States:
**DE FR GB**

(71) Applicant: **KABUSHIKI KAISHA TOSHIBA**
**72, Horikawa-cho**
**Saiwai-ku**
**Kawasaki-shi**
**Kanagawa-ken 210 (JP)**

(72) Inventor: **Komenaka, Kazuichi, c/o**
**Intell.Prop.Div.**
**K.K. Toshiba,**
**1-1 Shibaura 1-chome,**
**Minato-ku**
**Tokyo 105 (JP)**
Inventor: **Kobayashi, Kazuhito, c/o**
**Intell.Prop.Div.**
**K.K. Toshiba,**
**1-1 Shibaura 1-chome,**
**Minato-ku**
**Tokyo 105 (JP)**

(74) Representative: **Lehn, Werner, Dipl.-Ing. et al**
**Hoffmann, Eitle & Partner,**
**Patentanwälte,**
**Arabellastrasse 4**
**D-81925 München (DE)**

(54) **Resin-sealed semiconductor device and method of fabricating same.**

(57) Peel preventing bars (10) are formed in a grid form in an opening (41) provided at the center portion of a bed (62). A semiconductor chip (4) is adhered onto the bed (62) by an mount agent, which is prevented from flowing over the grid type peel preventing bars (10) in the opening (41). This structure can allow a mold resin (1) to sufficiently enter between the chip (4) and the peel preventing bars (10), thus preventing the resin from peeling due to high temperature after hardening.

FIG. 7

The present invention relates to a resin sealing structure for a resin-sealed semiconductor device and a structure of a lead frame for use in this semiconductor device.

Since resin-sealed semiconductor device are easy to be packaged and are suitable for mass-production, they are used typically. Such a resin-sealed semiconductor device is manufactured by using a lead frame which is formed by etching or pressing (punching) a thin metal plate of copper or an iron-nickel based alloy. The lead frame has a pattern for a chip mounting portion (hereinafter called "bed") where a semiconductor element, such as a semiconductor integrated circuit, (hereinafter called "chip") is mounted within the frame, suspending pin portions for supporting the bed, lead portions to which bonding wires are to be connected, etc. After the chip is mounted, the lead frame is placed in a mold, the bed portion including the chip, the bonding wires, the suspending pin portions and portions of the leads are sealed with a resin using a transfer mold method or the like, and unnecessary portions of the pattern are cut away, thus fabricating a semiconductor device. The lead portions which are unsealed with a resin and are exposed outside are shaped and are connected as outer leads to a printed circuit pattern of a printed circuit board. The distal end portions of the leads where the chip, bonding wires and the like are connected may be plated with gold or silver to improve the reliability of the connection.

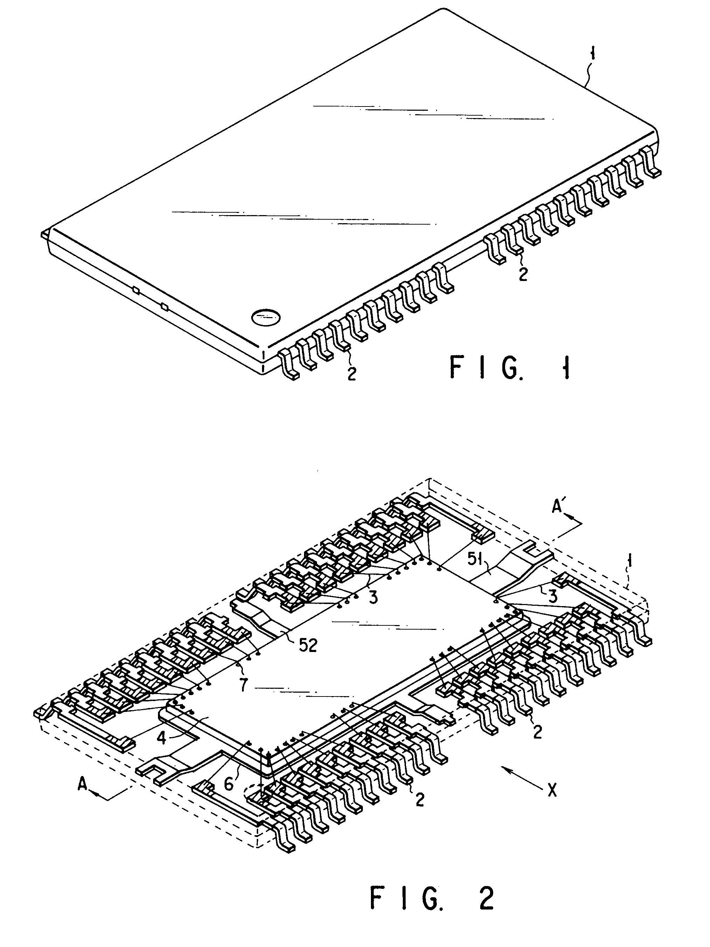

FIG. 1 presents a perspective view of a conventional TSOP (Thin Small Outline Package) resin-sealed semiconductor device. The figure shows the outline of the semiconductor device, which is specifically is a 400 mil and 40 pin type. The package body of the semiconductor device is made of a mold resin such as epoxy resin and is a rectangle having long sides and short sides. Leads (outer leads) 2, one row consisting of 10 pins, protrude from inside a two-row mold resin 1, and this semiconductor device has 40 pin leads, including the leads on the opposite side, which are electrically connected to a chip sealed in the mold resin 1.

FIG. 2 shows inside the mold resin 1. The mold resin portion 1 is indicated by broken lines to clearly shown the interior. Accommodated in the mold resin 1 is a lead frame excluding portions of the leads 2, the outer lead portions at the distal ends of the leads 2 being exposed from the mold resin 1. A bed 6 constituting the lead frame is placed nearly in the center of the mold resin 1. A chip 4 is mounted on the top surface of this bed 6 by an adhesive. Pins 51 and 52 are respectively provided at the short sides and long sides of the bed 6, protruding horizontally from the associated sides. Electrode pads 7 as connection electrodes are formed on the major surface of the chip 4. Although the electrode pads 7 are provided along the periphery of the chip 4, they may be formed closer to the center or may be arranged irregularly or regularly.

While the outer lead portions of the leads 2 constituting the lead frame are exposed from the mold resin 1, the inner lead portions have the surfaces plated with silver (shaded portions) and are arranged to face the bed 6. The silver-plated inner lead portions and the electrode pad portions 7 of the chip 4 are connected by bonding wires 3 such as gold wires to ensure electric conduction between the chip 4 and the leads 2.

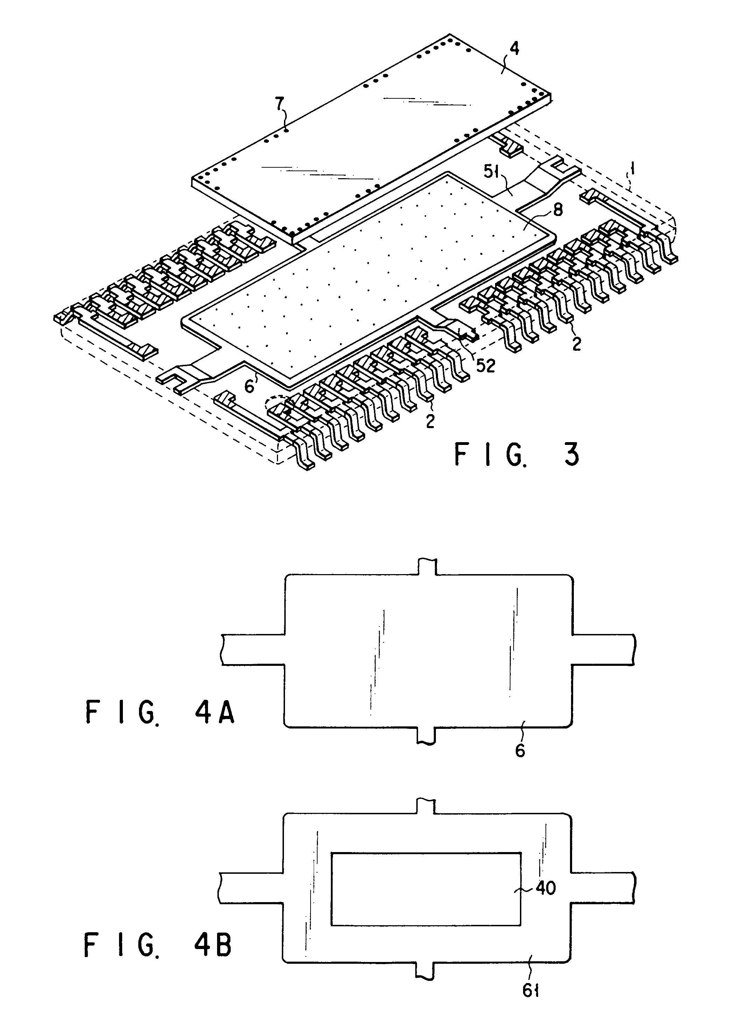

FIG. 3 is a perspective view of the semiconductor device with the chip separated from the bed. A mount agent 8 of epoxy-based resin is coated on the bed 6 in nearly the same area as the chip 4, thus adhering the chip 4 to the bed 6.

As shown in a plan view in FIG. 4A, the conventional bed 6 has the shape of a single flat plate slightly larger than the chip 4.

It is important to cope with a crack occurring in the mold resin in such a resin-sealed semiconductor device. Therefore, many measures have been taken, such as improvement on the adhesion between the bed for securing the chip and the leads and the mold resin, prevention of penetration of water into the mold resin and improvement of the resin strength. Particularly, in the case where a resin-sealed semiconductor device having a mold resin that has absorbed moisture is mounted on a printed circuit board by a heat treatment, such as an IR reflow or VPS reflow, cracks may occur in the mold resin at the back of the bed. It is important to prevent the occurrence of cracks to thereby improve the reliability of the resin-sealed semiconductor device.

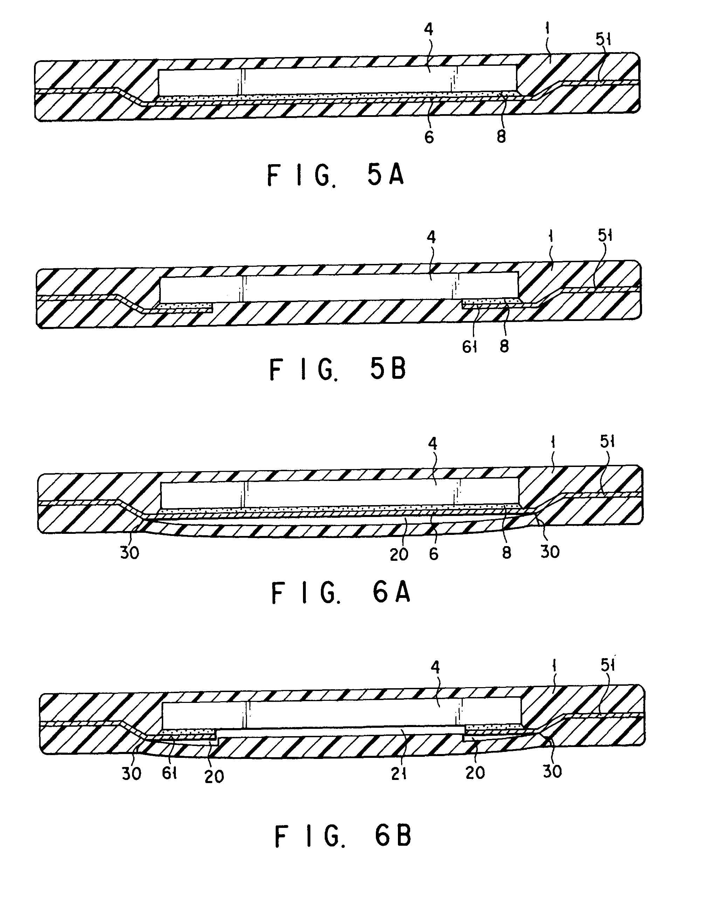

FIG. 5A shows a cross section of a portion along the line A-A' in FIG. 2. The figure shows around the suspending pins 51 cut along the line A-A' from the direction of an arrow X. The bed 6 having the suspending pins 51 at both ends is provided at nearly the center of the mold resin 1, and the mount agent 8 is formed on the bed 6 in an area slightly smaller than the bed area. The chip 4 having substantially the same area as the mount agent is placed on the mount agent 8 and is secured to the bed 6 by the mount agent 8. The bed 6 in a flat state has a size greater than that of the chip 4.

A description will be given of how cracks occur in the mold resin where such a single plate-like bed is accommodated, with reference to FIG. 5A and FIG. 6A. With the mold resin 1 having absorbed moisture in the air or being in a moisture-absorbed state, if the IR reflow or VPS reflow is carried out to mount the resin-sealed semiconductor device, the absorbed water is concentrated on minute gaps present at the boundary between the bottom of the bed 6 and the mold resin 1, forming a pool. This pool is evaporated by the heat by the IR reflow or VPS reflow, so that the internal pressure is produced at the bottom of the bed 6. As a result, a peel 20 occurs by the vapor pressure and the deformation of the bottom of the mold resin 1 caused by this peel causes cracks 30 at the edge portions of the bed 6 as shown in FIG. 6A. The occurrence of the cracks results in a defective appearance and causes defects due to water penetration when a humidity tent is conducted.

A conventional measure for preventing the occurrence of cracks will be described with reference to FIG. 4B, FIG. 5B and FIG. 6B. FIG. 5B and FIG. 6B are cross-sectional views of a resin-sealed semiconductor device having a bed shape different from the one in FIG. 5A, and FIG. 4B is a plan view of a bed portion used for that resin-sealed semiconductor device. This example is characterized in that, as shown in FIG. 4B, an opening 40 is formed in nearly the center portion of a bed 61 on which a chip is mounted. Since the use of this bed reduces the area of the minute gaps with poor adhesion present at the boundary between the bottom of the bed 61 and the mold resin 1, the area of a peel caused at the time the IR reflow or VPS reflow is executed is reduced, resulting in the suppression of the occurrence of cracks. In this prior art, the opening 40 of the bed 61 exposes the bottom of the chip 4 and the bottom directly contacts the mold resin 1, thus improving the adhesion strength of the mold resin as compared with the bed without an opening. This is because the adhesion strength between the chip and the mold resin is greater than that between the bed and the mold resin.

While the use of the bed having an opening should suppress the occurrence of cracks, its effect is actually small so that if the IR reflow or VPS reflow is carried out after the humidity absorption, the peel 20 occurring on the bed 61 also separates the portion where the chip 4 and mold resin 1 are adhered, producing a new peel 21, as shown in FIG. 6B. After all this provides the same condition as shown in FIG. 6A, producing cracks 30.

The present invention has been devised under the above situations, and it is an object of this invention to provide a resin-sealed semiconductor device which prevents peeling of the boundary between the back of a bed and mold resin when an IR reflow or VPS reflow is performed in a moisture-absorbed state, thus preventing the occurrence of cracks, and a method of fabricating the same.

The present invention is characterized by the formation of peel preventing means for preventing a resin from peeling from a bed at an opening portion of the bed having an opening in near the center. Another feature lies in that inhibiting means for inhibiting the flow of a mount agent into an opening having the peel preventing means is formed at the periphery of the opening. More specifically, a resin-sealed semiconductor device of the present invention comprises a chip, a bed where the chip is mounted and which has an opening, leads arranged apart from one another around the bed, a mount agent for bonding the chip to the bed, bonding wires for connecting connection electrodes, formed on the surface of the chip, to the leads, and a mold resin for covering the chip, the bed, the mount agent, the bonding wires and portions of the leads, whereby the opening of the bed has a plurality of peel preventing bars for preventing the mold resin from peeling from the back of the chip, and the mold resin fills the space between the peel preventing bars and the bed. Inhibiting means for inhibiting the mount agent from flowing over the peel preventing bars may be formed around the opening of the bed. A dam, a through hole or the like is used for the inhibiting means.

At least some of the plurality of peel preventing bars may be connected to the inner periphery of the opening, and a portion of the peel preventing bar to be connected to the inner periphery of the opening may be made thinner than the other portion. The peel preventing bars may be made thinner than the bed so that the distance between the bottom of the chip and the peel preventing bars becomes greater than the distance between the bottom of the chip and the surface of the bed. The opening may be covered with the chip to be connected to the bed, at least one recess or through hole may be formed around the opening, and at least a portion of the recess or through hole may not be covered with the chip. A method of fabricating a resin-sealed semiconductor device according to the present invention comprises the steps of providing a plurality of peel preventing bars at an opening formed in a center portion of a bed, supplying a mount agent to the bed from a plurality of nozzles, placing a chip on the bed and pressing the chip to adhere the chip to the bed, arranging leads apart from one another around the bed, electrically connecting connection electrodes, formed on the surface of the chip, to the leads, and covering the chip, the bed, the mount agent, the bonding wires and portions of the leads with a mold resin, whereby at the time of supplying the mount agent from the nozzles, supply positions of the mount agent are adjusted in such a way that when the chip is placed on and pressed against the bed, the mount agent does not flow over the peel preventing bars formed at the opening.

The provision of the peel preventing means, such as peel preventing bars, at the opening portion of the bed can suppress the peeling of the mold resin from the bed, thus preventing cracks from occurring in the

EP 0 655 782 A2

mold resin. Further, the formation of the inhibiting means, such as a dam or through hole, can inhibit the mount agent from flowing over the peel preventing means.

This invention can be more fully understood from the following detailed description when taken in conjunction with the accompanying drawings, in which:

FIG. 1 is a perspective view of a conventional semiconductor device;

FIG. 2 is a perspective view of the conventional semiconductor device;

FIG. 3 is a perspective view of the conventional semiconductor device;

FIGS. 4A and 4B present plan views of beds for use in the conventional semiconductor device;

FIGS. 5A and 5B present cross-sectional views of the semiconductor device along the line A-A' in FIG. 2;

FIGS. 6A and 6B present cross-sectional views of the semiconductor device along the line A-A' in FIG. 2;

FIG. 7 is a perspective view of a resin-sealed semiconductor device;

FIG. 8 is a perspective view showing the semiconductor device with a chip in FIG. 7 separated;

FIG. 9 is a cross-sectional view of the semiconductor device along the line B-B' in FIG. 7;

FIG. 10 is a plan view of a bed used in the semiconductor device in FIG. 7;

FIG. 11 is a cross-sectional view of the semiconductor device along the line B-B' in FIG. 7;

FIG. 12 is a fragmentary cross-sectional view of an area Z shown in FIG. 11;

FIGS. 13A to 13C present plan views of beds for use in a semiconductor device according to a second embodiment;

FIGS. 14A and 14B present plan views of beds for use in a semiconductor device according to a third embodiment;

FIGS. 15A and 15B present plan views of beds for use in a semiconductor device according to the third embodiment;

FIGS. 16A and 16B are cross-sectional views of a step of connecting the chip and bed of the semiconductor device according to the third embodiment;

FIGS. 17A and 17B are cross-sectional views of a step of connecting the chip and bed of the semiconductor device according to the third embodiment;

FIGS. 18A and 18B are fragmentary cross-sectionals view of a semiconductor device for explaining the advantages of the present invention;

FIGS. 19A and 19B present plan views of beds for use in a semiconductor device according to a fourth embodiment;

FIG. 20 is a plan view of a bed for explaining the fourth embodiment;

FIGS. 21A and 21B present plan views of beds for use in a semiconductor device according to the fourth embodiment;

FIGS. 22A and 22B present plan views of beds for use in a semiconductor device according to a fifth embodiment;

FIGS. 23A and 23B present plan views of beds for use in a semiconductor device according to the fifth embodiment;

FIGS. 24A and 24B present plan views of beds for use in a semiconductor device according to the fifth embodiment;

FIGS. 25A and 25B present plan view of beds for use in a semiconductor device according to the fifth embodiment;

FIGS. 26A and 26B are plan views of a bed for use in a semiconductor device according to the fifth embodiment;

FIGS. 27A to 27C present plan views of beds for use in a conventional semiconductor device and semiconductor devices of the present invention for explaining the advantages of this invention;

FIGS. 28A and 28B are plan views of a bed for use in a semiconductor device according to a sixth embodiment;

FIG. 29 is a plan view of a bed for use in a semiconductor device according to a seventh embodiment;

FIGS. 30A and 30B present cross-sectional views of the semiconductor device along the lines A-A' and B-B' in FIG. 29;

FIG. 31 is a plan view of a bed for use in a semiconductor device according to an eighth embodiment;

FIGS. 32A and 32B present cross-sectional views of the semiconductor device along the lines A-A' and B-B' in FIG. 31;

FIG. 33 is a plan view of a bed for use in a semiconductor device according to a ninth embodiment;

FIGS. 34A and 34B present plan views and a cross-sectional view of a bed for use in a semiconductor device according to a tenth embodiment; and

FIG. 35 is a cross-sectional view of a semiconductor device for explaining the advantages of the present invention.

4

Embodiments of the present invention will now be described with reference to the accompanying drawings.

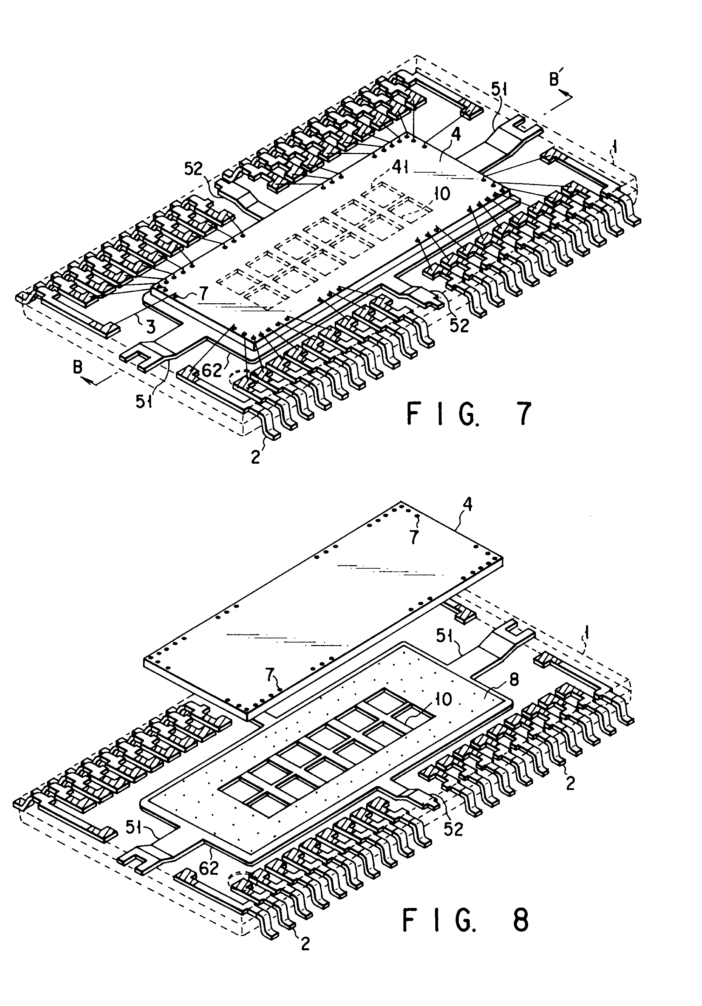

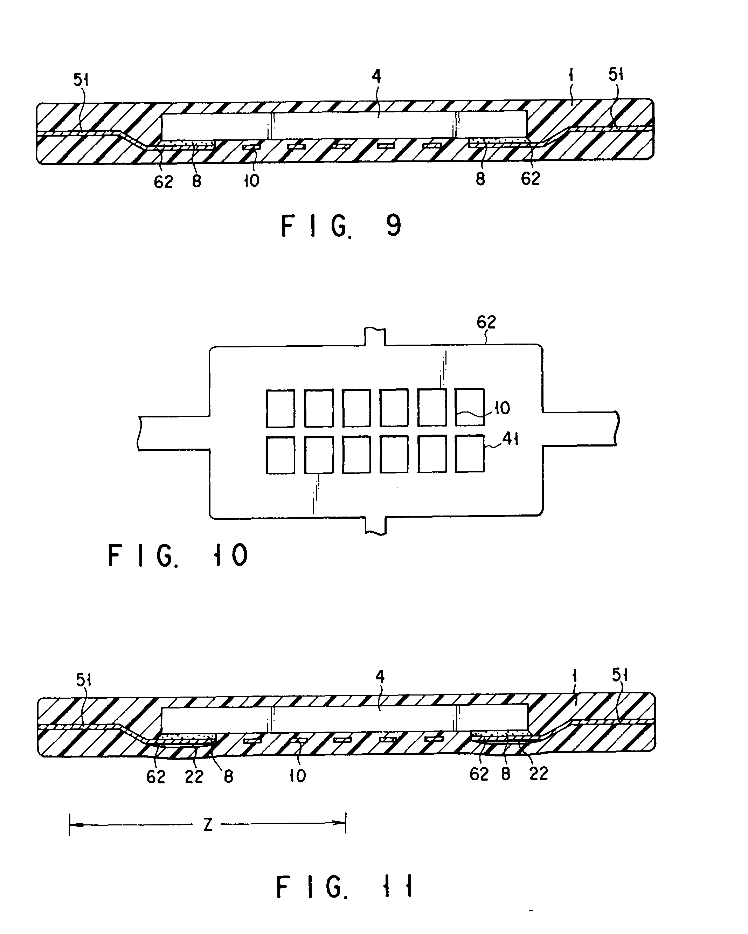

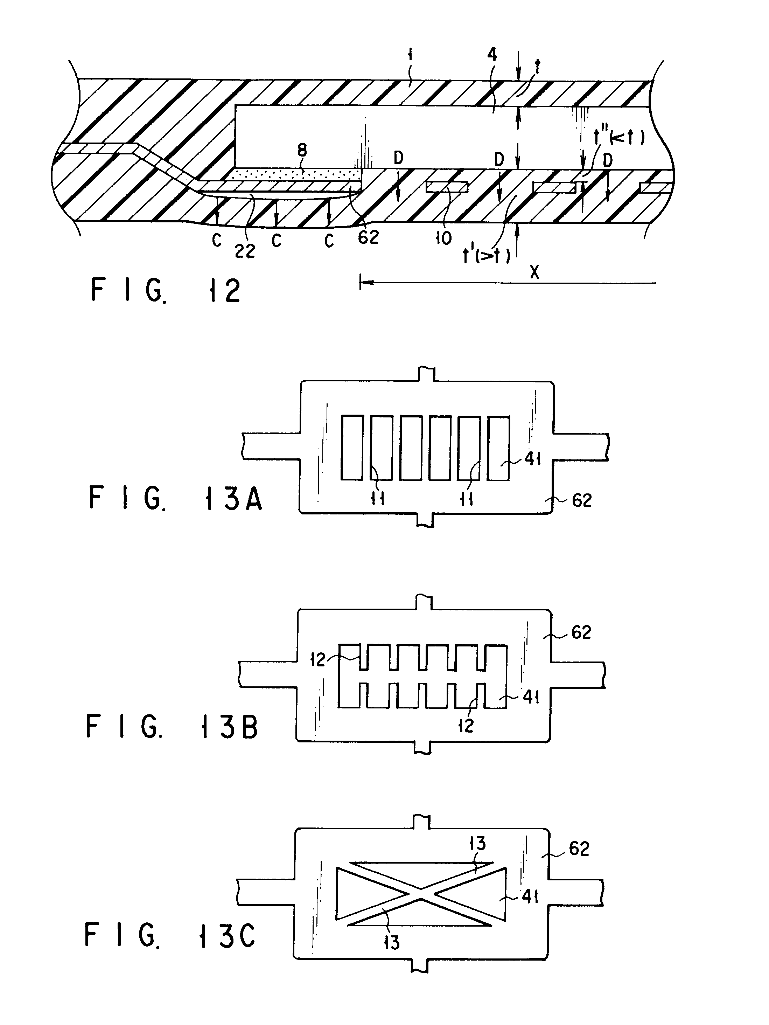

To begin with, a first embodiment will be described referring to FIGS. 7 through 12. FIG. 7 is a perspective view of a resin-sealed semiconductor device, FIG. 8 is a perspective view showing the resin-sealed semiconductor device with a semiconductor chip (semiconductor element) separated therefrom, FIG. 9 is a cross-sectional view along the line B-B' in FIG. 7, FIG. 10 is a plan view of a bed used in the resin-sealed semiconductor device, FIG. 11 is a cross-sectional view along the line B-B' in FIG. 7 for explaining the advantages of the present invention, and FIG. 12 is an enlarged fragmentary cross-sectional view of an area Z shown in FIG. 11 for explaining the advantages of the present invention. In FIG. 7, a mold resin of a package is indicated by broken lines and peel preventing means which is not actually visible is indicated by broken lines in the chip portion to explain the interior of the semiconductor device. A bed 62, i.e., a semiconductor element mounting portion, is located nearly in the center of a mold resin 1 of epoxy resin. The bed 62 is rectangular, for example, and a suspending pin 51 is attached to each of two short sides while a suspending pin 52 is attached to each of two long sides to secure the bed to the frame. A chip 4 is adhered onto the bed 62 by a mount agent. A plurality of electrode pads 7 as connection electrodes are formed on the major surface of the chip 4 at arbitrary intervals along the chip's periphery.

Leads 2 are arranged around the bed 62 with their one ends facing the bed 62 while the other ends of the leads 2 are exposed as outer leads from the mold resin 1. Two rows of leads 2 each row containing 10 pins are attached to one long side of the mold resin 1, so that the semiconductor device has 40 pin leads including the leads 2 on the opposite long side. One ends of the leads 2 are connected to the electrode pads 7 by bonding wires 3 such as gold wires. The leads 2 are arranged so as to facilitate the connection of the bonding wires 3. For the same reason, the electrode pads 7 are also arranged at predetermined positions on the chip 4. Therefore, the positions of the electrode pads 7 are not necessarily limited to the periphery of the chip 4, but may come more inward. The areas of the leads 2 where the bonding wires 3 are connected are plated with silver as indicated by hatches to facilitate the connection. A plurality of peel preventing bars 10 are used as the peel preventing means which characterizes the present invention in this embodiment. As the peel preventing bars are located under the chip 4 and are not visible in FIG. 7, those portions are indicated by broken lines as mentioned above. As shown in FIGS. 7 and 8, an opening (hole) 41 having almost the same rectangular shape as the bed 62 is formed in nearly the center of the bed 62.

The peel preventing bars 10 are formed in this opening 41, one nearly in the center vertically to the opposite short sides and five at nearly the equal intervals vertically the opposite long sides. Both ends of each peel preventing bar 10 are connected to the inner sides of the opening 41. Regarding FIG. 8, the surface status of the bed 62 will be explained. In the diagram, the bonding wires are omitted and the mold resin 1 is indicated by broken lines as in the previous drawings. The opening 41 formed in the bed 62 has nearly the same rectangular shape as the chip 4, but is slightly smaller in area than the chip. A mount agent 8 is coated between the opening 41 and the outer sides of the bed 62, and is not coated on the peel preventing bars 10. To improve the adhesion, care should be taken not to form the mount agent 8 on the peel preventing bars 10. After the coating of the mount agent 8, the chip 4 is mounted and is secured to the bed 62. This way space (clearance) can be formed between the peel preventing bars 10 and the back of the chip 4 by the thickness of the mount agent 8.

Next, the fabrication steps until the mold resin is formed in the semiconductor device will be described. A metal plate of a copper alloy or a iron-nickel alloy of about 0.15 to 0.25 mm thick is patterned by etching or pressing, thus forming a lead frame having unit lead patterns repeatedly arranged in one direction. The lead frame has a pattern for a bed on which a chip having an integrated circuit or the like formed inside the frame is mounted, suspending pin portions for supporting the bed, lead portions to which bonding wires are to be connected, etc. The bed of the lead frame has a shape as shown in FIG. 8, and the mount agent is coated there to attach the chip. After the chip is mounted, the lead frame is placed in a mold, the bed portion including the chip, the bonding wires, the suspending pin portions and portions of the leads are sealed with a resin using a transfer mold method or the like, and unnecessary portions of the pattern are cut away, thus fabricating a resin-sealed semiconductor device. The mold resin in a fluid state enters the space, defined by the chip 4 and the peel preventing bars 10, from the clearance gaps of the peel preventing bars 10 formed in the opening 41, and after the mold resin 1 is solidified, the peel preventing bars 10 enhances the adhesion of the mold resin 1 to the back of the chip 4. The lead portions which are unsealed with a resin and are exposed outside are shaped and are connected as outer leads to a printed circuit pattern of a printed circuit board. The distal end portions of the leads where the bonding wires for connecting the electrode pads 7 on the chip 4 to the leads may be plated with gold, silver or the like to improve the reliability of the connection, and are plated with silver in this embodiment.

Next, the space defined by the chip 4 and the peel preventing bars 10 will be discussed with reference to the cross-sectional view of the semiconductor device in FIG. 9. The bed 62 is buried in the mold resin 1 in such a way that the chip 4 comes nearly the center of the mold resin 1. The bed 62 is integrally connected to the suspending pins 51, one end of the suspending pin 51 having only its end face exposed from the mold resin 1. The chip 4 is adhered to the bed 62 by the mount agent 8. The mount agent 8 is present only on the bed 62 and is not formed on the peel preventing bars 10. The bed 62 is provided in such a manner that both ends of the chip 4 rest on the mount agent 8. The peel preventing bars 10 are arranged at five equal intervals, and a gap by the thickness of the mount agent 8 is formed between the back of the chip 4 and the top surfaces of the peel preventing bars 10, the gap being filled with the mold resin 1. FIG. 4 is a plan view of the bed 62 used in this embodiment, and six peel preventing bars 10 are formed along the shot sides and long sides of the opening 41. The portions where the individual peel preventing bars 10 cross one another are integrated.

The function and advantage of the first embodiment will be described with reference to FIGS. 11 and 12. FIG. 11 is a cross-sectional view of the resin-sealed semiconductor device for explaining the status when the resin-sealed semiconductor device in FIG. 9 has absorbed moisture and the IR reflow or VSP reflow is carried out at the mounting time, and shows the same cross section as FIG. 9. FIG. 12 is an enlarged cross-sectional view of an area Z shown in FIG. 11. In the resin-sealed semiconductor device, moisture in the air is pooled at the boundary between the back of the bed 62 in the mold resin and the mold resin 1, passing from the end faces of the suspending pins 51 and 52, exposed to the surface of the mold resin 1, and through the minute gaps at the boundary between those pins and the mold resin 1, or is mainly absorbed from the surface of the mold resin 1 and is dispersed in the mold resin 1 and stays there. If this resin-sealed semiconductor device is heated by executing the IR reflow or VSP reflow to mount the resin-sealed semiconductor device on a printed circuit board, the reflow-oriented heat concentrates the moisture, absorbed in such a manner, in the minute gap between the back of the bed 62 and the mold resin 1, and vaporizes it. The vapor increases the internal pressure, causing a peel 22 at the boundary between the back of the bed 62 and the mold resin 1. As shown in FIG. 12, the high-pressure vapor, which has no place to escape even after the peel 22 is produced by the separation of the mold resin 1 from the bed 62, escapes to an area X under the chip 4, generating peeling force D under the back of the chip 4 together with the force C generated by the peel 22 to separate the back of the chip 4 from the mold resin 1. According to the prior art, the chip 4 peels off the mold resin 1, causing cracks as shown in FIGS. 6A and 6B, whereas according to the present invention, the presence of the peel preventing bars 10 restricts the peeling to the peel 22 at the back of the bed 62 and prevents the occurrence of cracks.

A second embodiment will be described below with reference to FIGS. 13A to 13C.

The drawings present plan views of beds for use in a resin-sealed semiconductor device. The shape of the peel preventing bar as the peel preventing means is not limited to that of the first embodiment. In the first example of the second embodiment, the peel preventing bars are not attached to the short sides of the opening 41 formed in the bed 62, and peel preventing bars 11 are put at five equal intervals vertically to the long sides. Their both ends are connected to the inside of the opening 41 (FIG. 7A). In the second example, the peel preventing bars are not attached to the short sides as in the first example, and five peel preventing bars 12 are attached vertically to each long side, a total of ten on both sides. While one ends of the peel preventing bars 12 are attached to the long sides of the opening 41, the other ends are free and face the other ends of the other peel preventing bars 12 at some distance (FIG. 7B). The third example has two peel preventing bars 13 diagonally connecting the four corners of the opening 41 of the bed 62, with the crossing portions being integrated (FIG. 7C). In any case, at the time the mold resin 1 is formed by the transfer mold, the mold resin 1 enters the gap between the back of the chip 4 and the peel preventing bars 11, 12, 13 from between the opening 41 and the peel preventing bars, and is hardened, thus forming a package where it is adhered to the back of the chip 4.

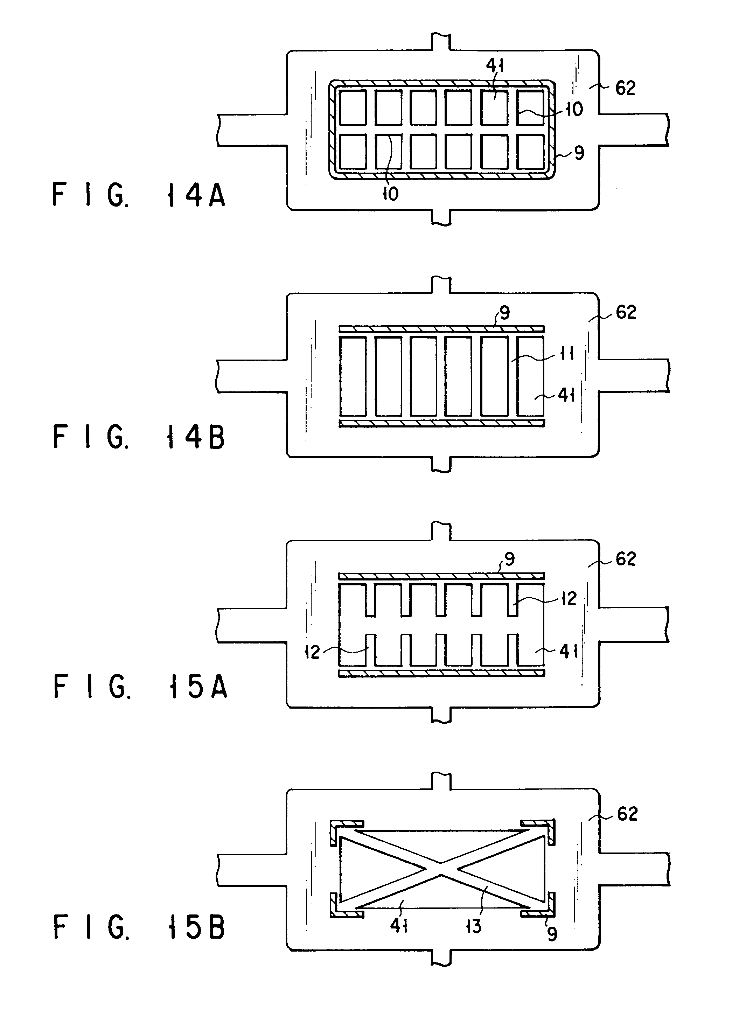

A third embodiment will be described below with reference to FIGS. 14A through 18B.

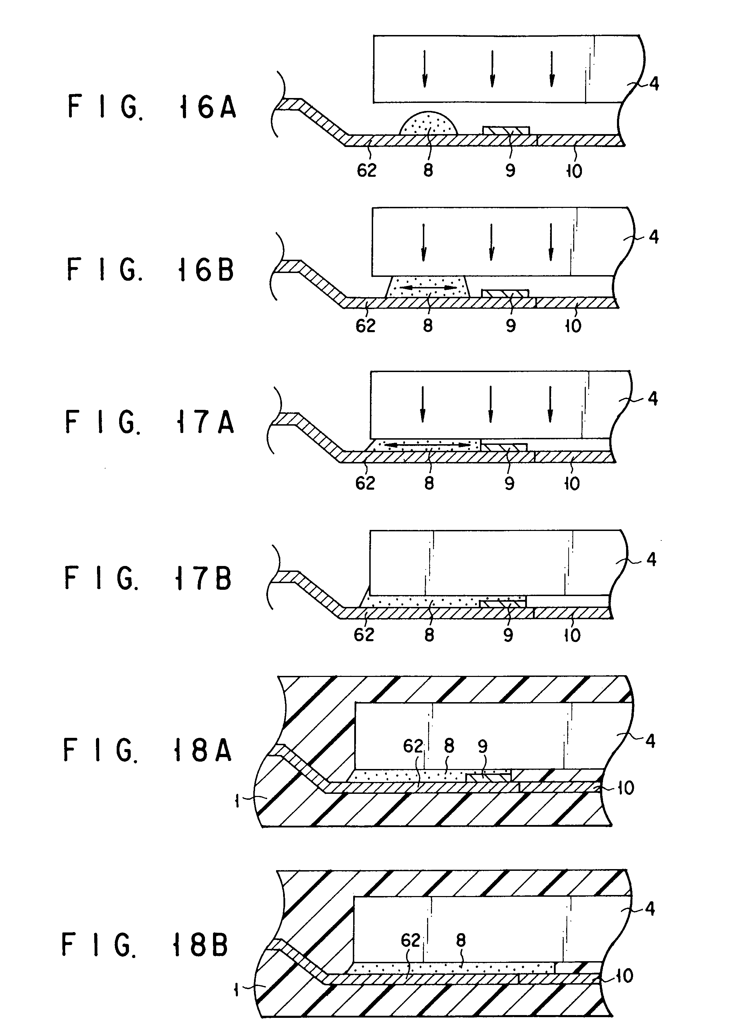

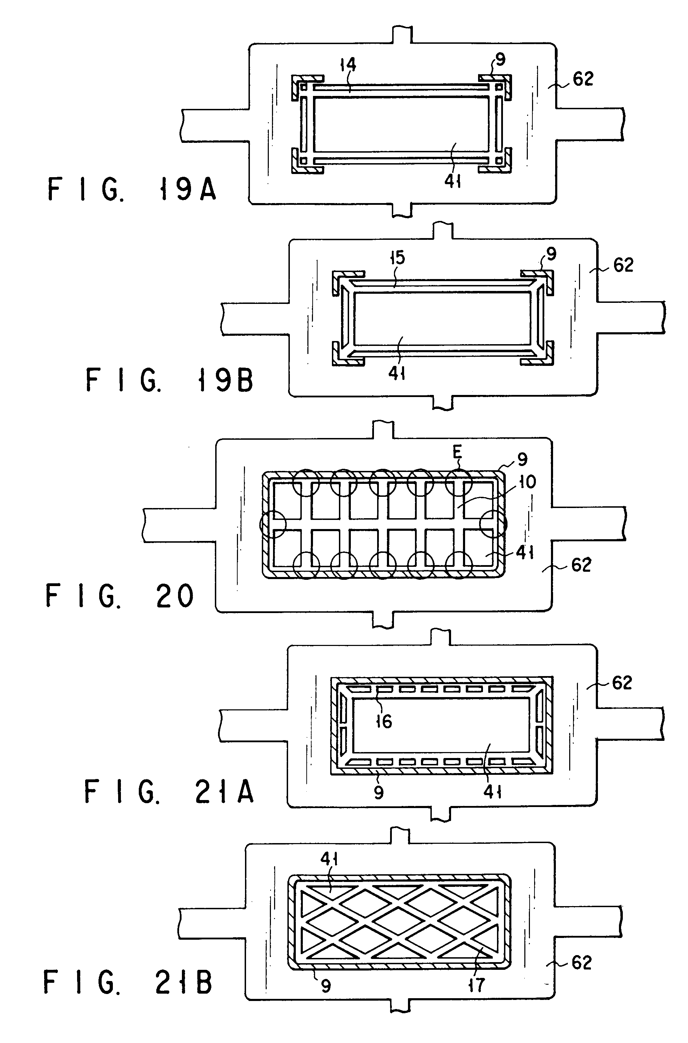

FIGS. 14A and 14B and FIGS. 15A and 15B present plan views of beds for use in a resin-sealed semiconductor device. FIGS. 18A and 18B are fragmentary cross-sectional views of the resin-sealed semiconductor device for explaining the function of a dam. FIGS. 16A and 16B and FIGS. 17A and 17B are cross-sectional views of a step of connecting the chip and bed via the dam. In the case where the chip is fixed to the bed using a mount agent, the mount agent in a fluid state may enter the opening and reach over the peel preventing bars. When the mount agent flows to the opening in this manner, the mount agent, serving as a spacer in this invention to secure the space between the back of the chip and the peel preventing bars which is to be filled with the mold resin, partially flows to the peel preventing bars so that the space cannot be secured sufficiently. Further, as the mount agent enters the space which is to be filled with the mold resin, the adhesion of the mold resin with respect to the chip is impaired accordingly.

Therefore, the flow of the mount agent over the peel preventing bars should be avoided as much as possible. This embodiment is designed to inhibit the mount agent from flowing over the peel preventing bars and is characterized in that a dam is formed around the opening on the surface of the bed where the mount agent is coated. In this embodiment, a plated layer, such as Ag plating, is used as the dam.

In the first example where Ag plating is used as a dam, the bed 62 used in the first embodiment shown in FIG. 10 is used. Formed at the opening 41 of the bed 62 are one long peel preventing bar 10 having both ends connected to the short sides and five short peel preventing bars 10 having both ends connected to the long sides. An Ag plated layer 9 is formed in a doughnut shape along the periphery of the opening 41 of this bed 62. This Ag plated layer 9 is sandwiched between the bed 62 and the chip 4 and prevents the mount agent intervening therebetween from flowing to the opening 41 (FIG. 14A). The second example uses the bed used in the first example of the second embodiment. Five peel preventing bars 11 have both ends connected to the long sides of the opening 41 nearly at equal intervals and a peel preventing bar crossing those peel preventing bars and connected to the short sides is not used. As the connection portions to the peel preventing bars 11 are present only on the long sides of the opening 41, therefore, the Ag plated layers 9 are formed only along the long sides. Since one of main purposes of forming the Ag plated layer 9 is to prevent the mount agent from ride over the peel preventing bars, the intrinsic function and advantage can be maintained sufficiently even if the Ag plated layer is not formed at the shot sides where there are no connection portions to the peel preventing bars (FIG. 14B). In the third example, the Ag plated layers 9 are formed only along the long sides of the opening 41 for the same reason as given for the second example. This example uses the bed used in the second example of the second embodiment. Peel preventing bars 12 are formed only at the long sides of the opening 41 formed in the bed 62 (FIG. 15A). The fourth example uses the bed used in the third example of the second embodiment. This example has two peel preventing bars 13 diagonally connecting the four corners of the opening 41 of the bed 62, with connecting portions for the opening 41 and the peel preventing bars 13 being located at the four corners. To prevent the penetration of the mount agent over the peel preventing bars 13, therefore, the Ag plated layers 9 are formed at the four corners and are not particularly formed at other portions (FIG. 15B).

With reference to FIGS. 16A through 18B, a description will now be given of a step of connecting the chip to the dam-formed bed in this embodiment and the function of the dam used as the aforementioned inhibiting means. FIGS. 16A, 16B and 17A, 17B are cross-sectional views of a connecting step, and FIGS. 18A, 18B are fragmentary cross-sectional views for explaining the function of the dam. The same bed as used in the first embodiment is used. The Ag plated layer 9 having a thickness of about 8 $\mu$m is formed at the periphery of the opening 41 closer to the center of the bed 62. Then, the mount agent 8 is dispensed on the bed 62 outside the Ag plated layer 9. Under this situation, the chip 4 is mounted (FIG. 16A). When the chip 4 is mounted, the dispensed mount agent 8 extends and spreads by the pressure of the chip 4 (FIG. 16B). The mount agent 8 further extends and reach the Ag plated layer 9, but does not extend inside the bed 62 due to a dam 9 (FIG. 17A). Finally, the mount agent 8 stops its extension before exceeding the Ag plated layer 9 (FIG. 17B). When the chip 4 is mounted and bonded, the chip 4 is covered together with the bed 62, etc. with the mold resin 1.

In the case where the Ag plated layer 9 is provided on the bed 62 as a dam, at the time the chip 4 is mounted after dispensing the mount agent 8, the mount agent, even if its quantity is too much, is hindered by the Ag plated layer 9 and cannot penetrate to the peel preventing bars 10 (FIG. 18A). Therefore, the lowering of the adhesion strength of the mold resin 1 between the inner edge portions of the opening 41 and the connecting portions of the peel preventing bars 10 is prevented. If no Ag plated layer is present, on the other hand, when the amount of the mount agent 8 is too much in the case where the mount agent 8 is dispensed and the chip 4 is then mounted, it may penetrate to the peel preventing bars 10. If it penetrates, the adhesion strength of the mold resin 1 between the inner edge portions of the opening 41 and the connecting portions of the peel preventing bars 10 is lowered (FIG. 18B). Like the mount agent, the Ag plated layer used as a dam can also serve as a spacer which secures space between the back of the chip and the peel preventing bars where the mold resin can sufficiently fill. A semiconductor device packaged by the mold resin 1 is about 1 mm thick (FIG. 18A). The bed 62 is about 0.15 mm thick and the chip 4 is about 0.35 mm thick. The mount agent 8 between the chip 4 and the bed 62 is about 0.02 mm. At this time, the Ag plated layer 9 is set to 0.008 mm.

A fourth embodiment will be described below with reference to FIGS. 19A through 21B.

The diagrams show beds all having an Ag plated layer, and a feature lies in the arrangement of the peel preventing bars at the opening. In the first example, peel preventing bars 14 are provided in a # shape. The peel preventing bars 14 are connected two to the short sides and two to the long sides, and the individual peel preventing bars 14 are provided close to the associated sides. Therefore, the connecting portions for the peel preventing bars 14 and the associated inner sides of the opening are provided close to the four corners of the opening. As the Ag plated layers 9 are provided to separate the connecting portions of the peel preventing bars from the mount agent as described above, they are formed in the vicinity of the four corners of the opening 41 (FIG. 19A). While there are two connecting portions near each of the four corners of the opening 41 in the first example, the second example is characterized in that they are put together to one to connect to the associated corner. The Ag plated layers 9 are so formed as to surround the four corners of the opening 41 (FIG. 19B).

When the peel preventing bars are provided in a # shape as illustrated in this embodiment, the peel preventing bars are formed adjacent and in parallel within the opening, so that the adhesion between the edge portions of the opening and the mold resin is evenly improved. If the peel preventing bars are formed in a grid form like those used in the first embodiment, for example, the adhesion is not uniform. A bed in FIG. 20 has the same structure as the one at FIG. 14A and its adhesion has already been explained.

In the first embodiment including this figure, the peel preventing bars are connected at nearly equal intervals to the respective inner sides of the opening. As the peel preventing bars are arranged in a grid form as viewed in the plan view, the structure is called a grid type. In the grid type as shown in FIG. 20, encircled areas E have the greatest adhesion strength in the edge portions, and the areas between the peel preventing bars have smaller adhesion strength than the areas E so that the overall adhesion strength is uneven. In this respect, the #-shaped type can ensure even adhesion. Reinforced #-shaped type peel preventing bars 16 are formed at the opening 41 of the bed 62 as shown in FIG. 21A to further improve the adhesion. FIG. 21B is a modification of the grid type in which peel preventing bars 17 are designed in a diamond grid form. In any case, the Ag plated layer 9 is formed as a dam around the opening.

The step of connecting the chip to the bed via a dam has been discussed above with reference to FIGS. 16A and 16B. In the case where the chip is fixed to the bed using a mount agent, however, the mount agent in a fluid state may enter the opening and reach over the peel preventing bars. When the mount agent flows to the opening in this manner, the performance of the peel preventing bars is lowered. Although the formation of a dam such as Ag plating is performed to inhibit the flow of the mount agent over the peel preventing bars, a method of preventing the mount agent from flowing over the peel preventing bars without using a dam will be described. While this description refers to FIGS. 16A and 16B and FIGS. 17A and 17B, the Ag plated layer 9 in the diagrams is not employed. A plurality of nozzles for dispensing the mount agent are arranged on the periphery of the bed 62. The mount agent 8 is dispensed outward of the bed 62 to form a plurality of mount agents 8 on the bed 62. The positions of the nozzles are adjusted slightly outward so that the positions of the dispensed mount agents 8 come more outward than those in the third embodiment where the Ag plated layer 9 is present. Under this situation, the chip 4 is mounted. When the chip 4 is mounted, the dispensed mount agents 8 extend and spread by the pressure of the chip 4. As the positions of the nozzles are adjusted in such a way that the position of the first mount agent 8 comes slightly outward of the bed 62, the mount agents 8 further extend and approach the opening, but do not go beyond the opening over to the peel preventing bars 10. After the chip 4 is mounted and bonded, the chip 4 is covered together with the bed 62, etc. with the mold resin. Even if a dam is not formed, it is possible to prevent the mount agent from flowing over the peel preventing bars in this manner. This method can therefore be applied to an embodiment which, like the first embodiment, does not use a dam.

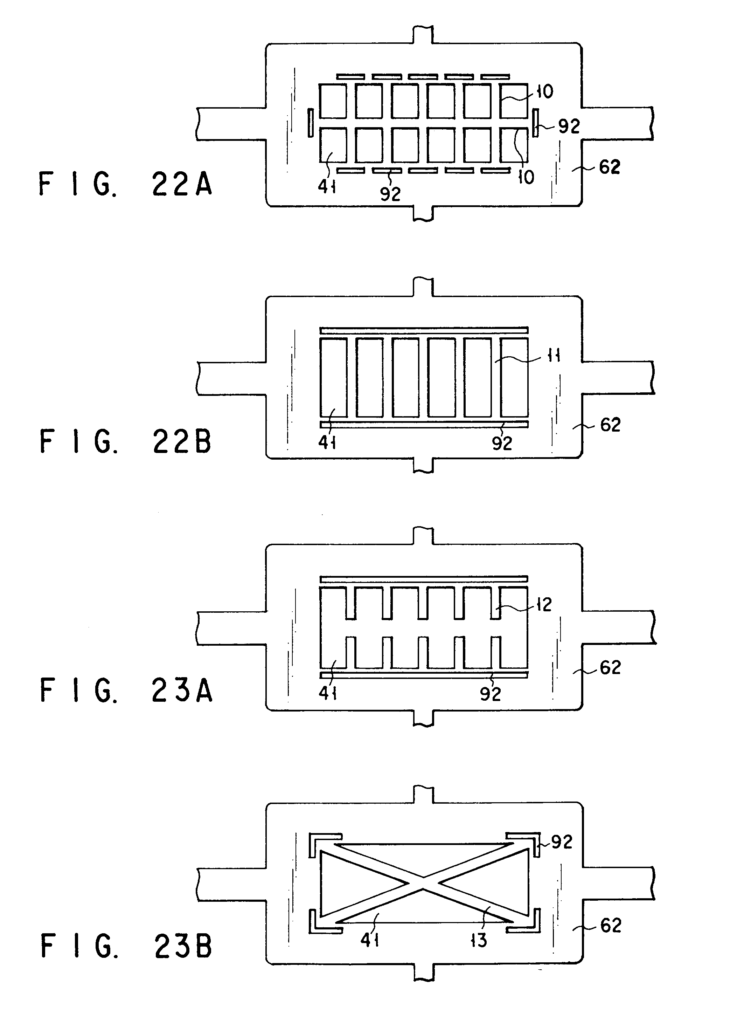

A fifth embodiment will be described below with reference to FIGS. 22A through 22B.

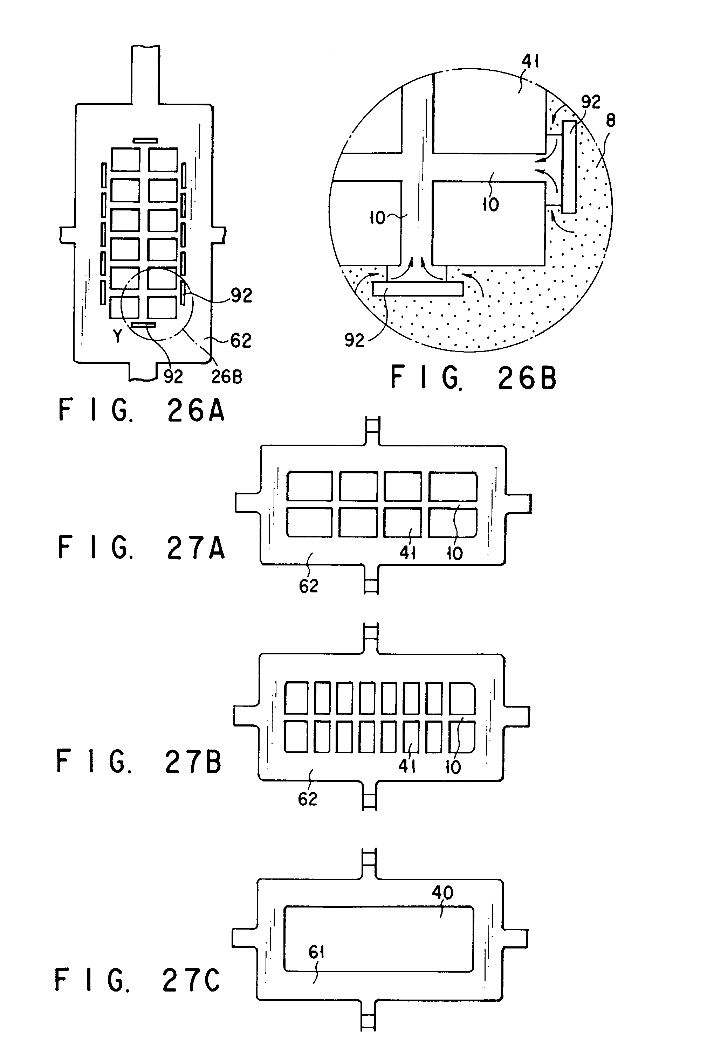

FIGS. 22A and 26B are plan views of beds for use in a resin-sealed semiconductor device, FIGS. 26A and 26B being a diagram for explaining the function of a mount-agent penetration preventing hole which characterizes this embodiment. In the case where the chip is fixed to the bed using a mount agent, the mount agent in a fluid state may enter the opening and reach over the peel preventing bars from the connecting portions of the peel preventing bars at the inner sides of the opening as described for the previous embodiments, causing shortcoming such that space cannot be maintained sufficiently and the adhesion of the mold resin with respect to the chip is impaired. This embodiment is designed to inhibit the mount agent from flowing over the peel preventing bars and is characterized in that a mount-agent penetration preventing hole (hereinafter called a penetration preventing hole) for preventing the penetration of the mount agent is formed, in place of the Ag plated layer, at the connecting portions of the peel preventing bars at the opening in the surface of the bed where the mount agent is coated. FIG. 26B is an enlarged view of an area Y (FIG. 26A) on the bed 62 shown in FIG. 22A. Even if the mount agent 8 is dispensed on the bed 62 in such a way as not to reach the opening 41, it may flow into the opening 41 and flow to the peel preventing bars 10 from the connecting portions. If penetration preventing holes 92 are formed in the bed 62 in such a way as to face the connecting portions, the mount agent 8 proceeds in narrow passages between the opening 41 and the penetration preventing holes 92 as indicated by arrows in the diagram, elongating the penetration passages, and do not therefore reach the peel preventing bars 10.

The positions of the penetration preventing holes can properly be adjusted by the widths of the penetration passages. In the first example, the bed 62 shown in FIG. 26A is used. Formed at the opening 41 of the bed 62 are one long peel preventing bar 10 having both ends connected to the short sides and five short peel preventing bars 10 having both ends connected to the long sides. A plurality of penetration preventing holes 92 are formed in an annular shape along the periphery of the opening 41 of this bed 62 in such a way as to face the connecting portions of the peel preventing bars 10 to the opening 41 (FIG. 22A). The second example uses the bed used in the first example of the second embodiment. Five peel preventing bars 11 have both ends connected to the long sides of the opening 41 nearly at equal intervals and a peel preventing bar crossing those peel preventing bars and connected to the short sides is not used. As the connection portions to the peel preventing bars 11 are present only on the long sides of the opening 41, therefore, the penetration preventing holes 92 are formed only along the long sides. The penetration preventing holes 92 are formed long along the long sides (FIG. 22B). In the third example, as in the second example, the penetration preventing holes 92 are formed only along the long sides of the opening 41. This example uses the bed used in the second example of the second embodiment. Peel preventing bars 12 are formed only at the long sides of the opening 41 formed in the bed 62 (FIG. 23A). The fourth example uses the bed used in the third example of the second embodiment.

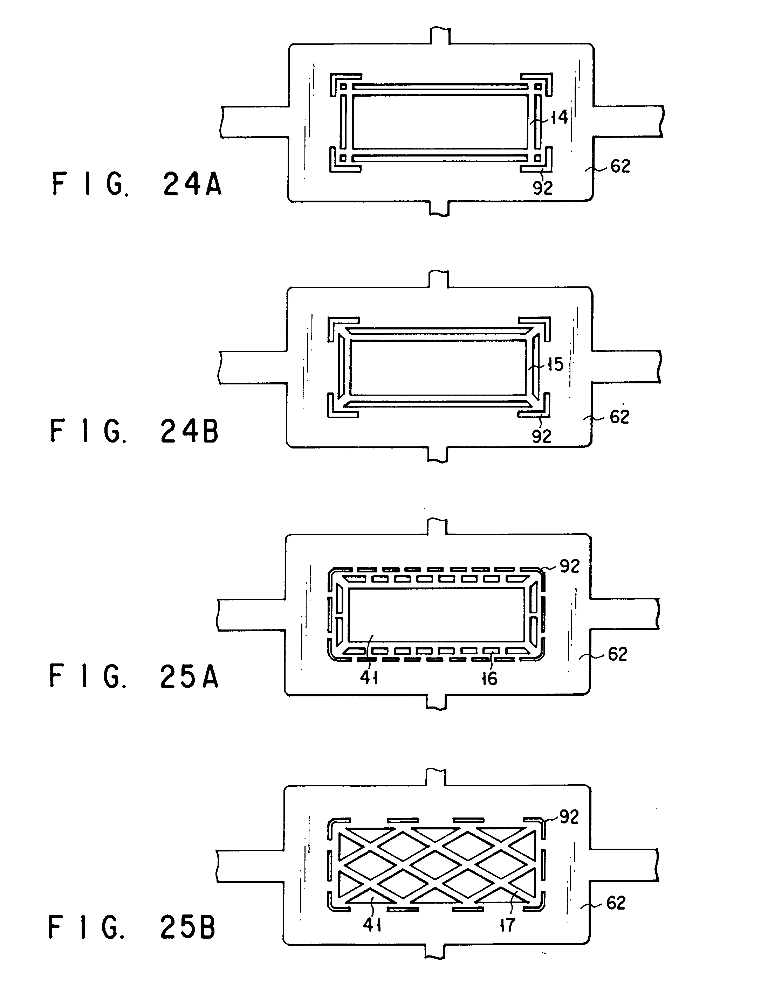

There are two peel preventing bars 13 diagonally connecting the four corners of the opening 41 of the bed 62, with connecting portions for the opening 41 and the peel preventing bars 13 being located at the four corners. The penetration preventing holes 92 are formed only at the four corners of the opening 41 (FIG. 23B). The fifth example uses the same bed as the first example of the fourth embodiment. The peel preventing bars 14 are provided in a # shape. The penetration preventing holes 92 are formed near the four corners of the opening 41 (FIG. 24A). While there are two connecting portions near each of the four corners of the opening 41 in the fifth example, the sixth example is characterized in that they are put together to one to connect to the associated corner. The penetration preventing holes 92 are so formed as to surround the four corners of the opening 41 (FIG. 24B). In the seventh example, reinforced #-shaped type peel preventing bars 16 are formed at the opening 41 of the bed 62 to further improve the adhesion (FIG. 25A). The eighth example is a modification of the grid type in which peel preventing bars 17 are designed in a diamond grid form (FIG. 25B). In any case, the penetration preventing holes 92 are formed around the opening 41.

The advantages of the present invention will now be described with reference to FIGS. 27A to 27C and Table 1. A description will be given of a TSOP type semiconductor device with 400 mil and 40 pins (the package having the short sides of 10.16 mm and 20 leads on each long side). FIGS. 27A to 27C present plan views illustrating the shapes of the bed/suspending pins of tested semiconductor devices, and show a conventional example and two examples of the present invention. Table 1 shows the results of a crack test. The chip size is 10.0 $\times$ 4.7 mm, the bed size is 10.6 $\times$ 5.3 mm, and the opening formed in the bed is 7.6 $\times$ 2.3 mm and is formed nearly in the center of the bed. The distance from the outer sides of the bed to the opening is about 1 to 2 mm in the present invention. The lead frame of a material of which the bed is formed consists of an iron alloy containing about 42 wt.% nickel and has a thickness of about 0.15 to 0.25 mm in this invention while a lead frame of 0.15 mm thick is used in the embodiments. The bed 62 in FIG. 27A is provided with four peel preventing bars 10, and the bed 62 in FIG. 27B is provided with eight peel preventing bars 10. The peel preventing bars 10 have a width of about 0.2 to 0.3 mm. Samples a and b shown in Table 1 are semiconductor devices of the present invention, which respectively have four peel preventing bars and eight peel preventing bars, and a sample c is a conventional semiconductor device having the opening 40 in the bed 61. The samples a, b and c respectively correspond to semiconductor devices in FIG. 27A, in FIG. 27B and in FIG. 27C. The individual samples undergone three types of humidity treatments of 85°C/60% $\times$ 168 hours, 30°C/60% $\times$ 192 hours and 30°C/60% $\times$ 216 hours and then tested under the condition that the IR reflow was to be carried out four times.

Table 1

| Sample | humidity condition | parameter | outer crack | inner crack | bed shape |
|---|---|---|---|---|---|
| a | 85°C/60% × 168 hrs | 66 | 0 | 0 | FIG. 27A |
|   | 30°C/60% × 192 hrs | 66 | 0 | 0 |   |
|   | 30°C/60% × 216 hrs | 66 | 0 | 0 |   |
| b | 85°C/60% × 168 hrs | 66 | 0 | 0 | FIG. 27B |
|   | 30°C/60% × 192 hrs | 66 | 0 | 0 |   |
|   | 30°C/60% × 216 hrs | 66 | 0 | 0 |   |
| c | 85°C/60% × 168 hrs | 66 | 24 | 0 | FIG. 27C |
|   | 30°C/60% × 192 hrs | 66 | 6 | 0 |   |
|   | 30°C/60% × 216 hrs | 66 | 6 | 0 |   |

As a result, cracks reaching the outside of the mold resin (external cracks) have occurred in the conventional sample c under any humidity condition. However, external cracks have not occurred in the samples a and b associated with the present invention under any humidity condition. There are two cases of the occurrence of cracks, though minute in amount, staying within the mold resin (inner cracks) for the sample a under the humidity condition of 30°C/60% × 216 hours. From this, the advantage of the peel preventing bars is apparent.

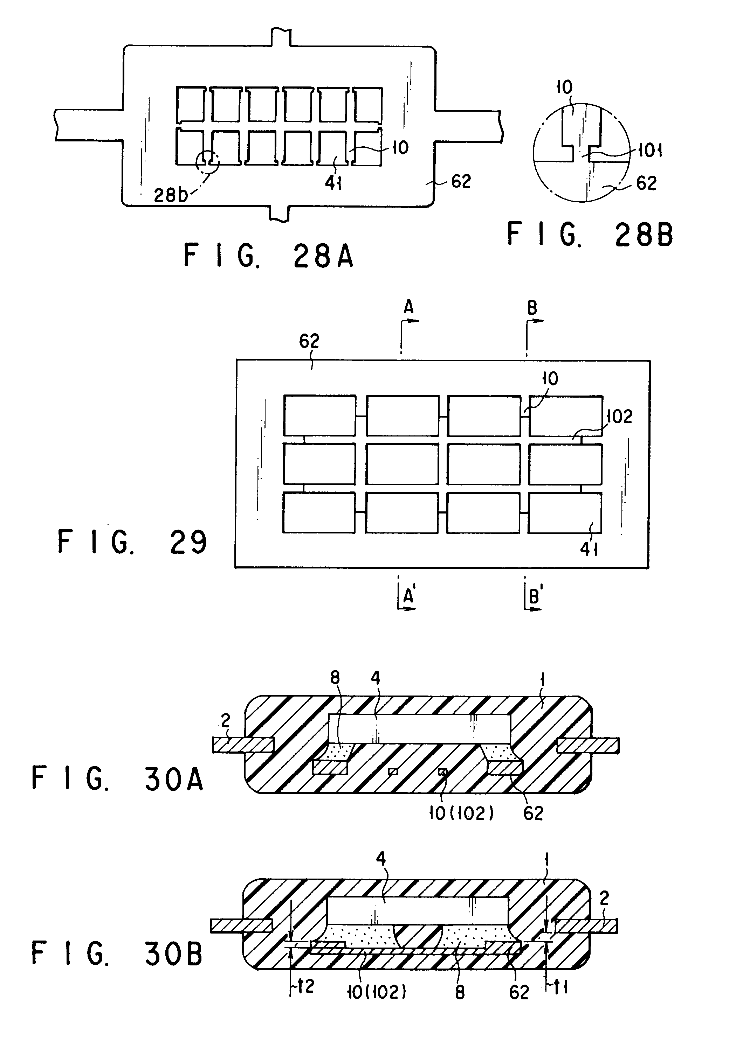

A sixth embodiment will now be described with reference to FIGS. 28A and 28B.

The drawing is a plan view of a bed for use in a semiconductor device. The peel preventing bars 10 have both ends connected to the long sides of the opening 41 of the bed 62 and are arranged at five equal intervals. Both ends of a single peel preventing bar 10 are connected to the short sides of the opening 41. The portions where the individual peel preventing bars 10 cross are integrated. This embodiment is characterized in that the connecting portions between the individual sides of the opening 41 and the peel preventing bars 10 are made smaller. That is, the feature lies in that each peel preventing bar 10 has small-sized portions 101 at both ends. By forming the small-sized portions 101 at the connecting portions of the peel preventing bars 10 to the inner sides of the opening 41, it is possible to effectively inhibit the mount agent from flowing over the peel preventing bars 10 when the chip is mounted. The proper width of the small-sized portions is about 1/3 to 1/2 of the width of the peel preventing bars.

A seventh embodiment will be described below with reference to FIG. 29 to FIG. 30B.

FIG. 29 is a plan view of a bed used in a resin-sealed semiconductor device of this embodiment, and FIGS. 30A and 30B present cross-sectional views of a resin-sealed semiconductor device which is completed by mounting a chip on the bed in the previous drawing and treating with the mold resin, the illustrated bed portions being in cross sections along the lines A-A' and B-B' in FIG. 29. In the present invention, at the time of mounting the chip on the bed having an opening and carrying out a treatment with the mold resin, it is necessary to improve the adhesion between the mold resin filling inside the opening and the chip. To do so, sufficient space should be secured between the bed and the chip so that the intervening mount agent should spread in the space and is prevented from extending over the peel preventing bars. The bed 62 shown in FIG. 29 has the peel preventing bars 10 provided in a grid form in the opening 41. That is, two peel preventing bars 10 are attached to the short sides in the opening 41 and three attached to the long sides. Although the peel preventing bars arranged in a grid form are subjected to no treatment in the first embodiment, the faces of the peel preventing bars 10 opposing the chip are subjected to half etching so as to form half etching areas 102 in areas excluding the connecting portions between the opening 41 and the peel preventing bars 10; the areas 102 being thinner than the other areas. The chip 4 is adhered and secured to the bed 62 by the mount agent 8, and is coated with the mold resin 1 after bonding, thus yielding the resin-sealed semiconductor device shown in FIGS. 30A and 30B. The leads 2 are provided in parallel above the bed 62 by t1 (about 1.0 mm). The half etching area 102 is thinner than the other area by t2 (about 0.5 to 1.0 mm). The formation of the half etching areas 102 permits the mold resin 1 to sufficiently fill in the space from the opening 41 to between the back of the chip 4 and the peel preventing bars 10, thus improving the adhesion.

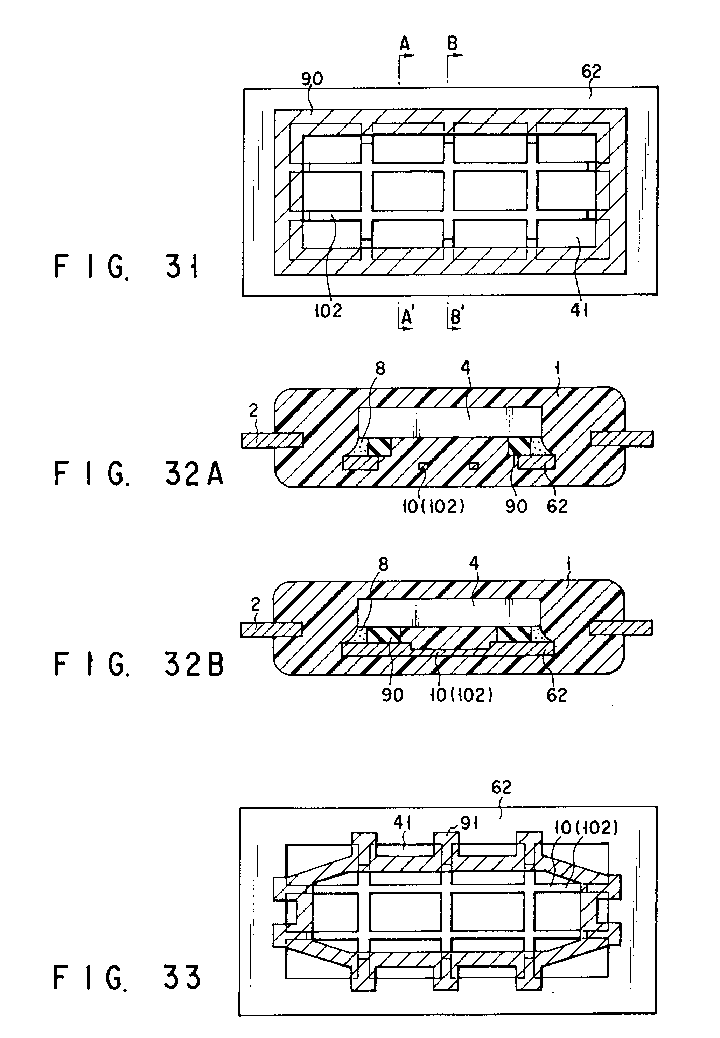

An eighth embodiment will be described below with reference to FIG. 31 and FIGS. 36A and 36B.

FIG. 31 is a plan view of a bed used in a resin-sealed semiconductor device of this embodiment, and FIGS. 32A and 32B present cross-sectional views of a resin-sealed semiconductor device which is completed by mounting a chip on the bed in the previous drawing and treating with the mold resin, the illustrated bed portions being in cross sections along the lines A-A' and B-B' in FIG. 31. Even if the chip/bed space is widened as in the previous embodiment, the mount agent 8 may enter there to make the presence of the peel preventing bars insignificant. Although the positions for dispensing the mount agent are shifted slightly outward or the Ag plated layer is formed to prevent this flow as discussed above, a polyimide resin film is used for a dam material for example in this embodiment. A polyimide film 90 is formed at the boundary between the bed 62 and the opening 41 in such a way as to cover the connecting portions of the peel preventing bars 10. As per the previous embodiment, the faces of the peel preventing bars 10 opposing the chip 4 are subjected to half etching so as to form half etching areas 102 in areas excluding the connecting portions between the opening 41 and the peel preventing bars 10; the areas 102 being thinner than the other areas. The chip 4 is adhered and secured to the bed 62 by the mount agent 8, and is coated with the mold resin 1 after bonding, thus yielding the resin-sealed semiconductor device shown in FIGS. 32A and 32B. The half etching area 102 is thinner than the other area by 2 mm. The formation of the half etching areas 102 permits the mold resin 1 to sufficiently fill in the space from the opening 41 to between the back of the chip 4 and the peel preventing bars 10, thus improving the adhesion and the polyimide film 90 prevents the mount agent 8 from entering over the half etching areas 102 of the peel preventing bars 10. To accomplish the effect, the polyimide film 90 should have a thickness of about 5 μmm or greater.

A ninth embodiment will be described below with reference to FIG. 33.

The drawing is a plan view of a bed for use in a resin-sealed semiconductor device. In the previous embodiment, a resin film of polyimide or the like is formed at the boundary between the bed 62 and the opening 41 in such a way as to cover the connecting portions of the peel preventing bars 10. Therefore, the mount agent 8 dispensed outside the bed 62 and having extended to the polyimide film 90 by the pressure of the chip 4 mounted on the bed 62 forms a void together with the polyimide film 90, forming an area where no mold resin is present in that portion (see FIG. 31 and FIGS. 32A and 32B). In this embodiment, therefore, a polyimide film 91 is formed over the interior of the opening 41 in such a way as to partially cover the half etching areas 102, thus providing projections which cover the connecting portions between the opening 41 and the peel preventing bars. This way the void sealed by the polyimide film 91 and the mount agent 8 can escape outside from the opening 41. Thus, the mount agent 8 can maintain the uniform adhesion.

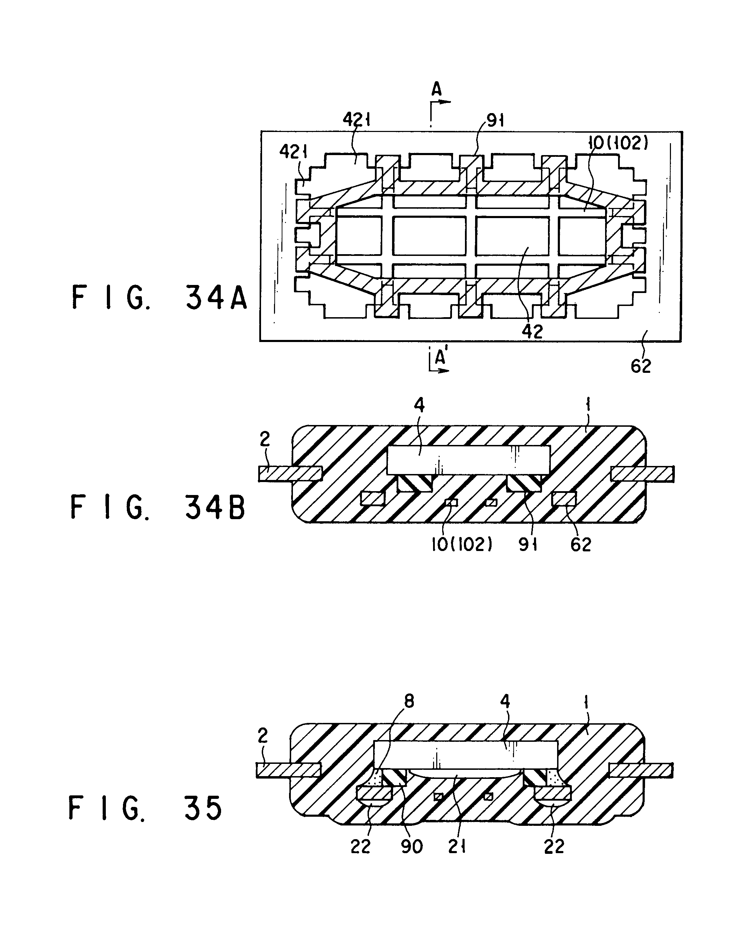

A tenth embodiment will be described below with reference to FIGS. 34A and 34B and FIG. 35.

FIGS. 34A and 34B present plan views of a bed for use in a resin-sealed semiconductor device of this embodiment and a cross-sectional view of the resin-sealed semiconductor device along A-A', completed by mounting a chip on this bed and treating with the mold resin, and FIG. 35 is a cross-sectional view of the resin-sealed semiconductor device for explaining the advantages of the present invention. As per the previous embodiment, the polyimide film 91 is formed over the interior of the opening 41 in such a way as to partially cover the half etching areas 102, and projections which cover the connecting portions between the opening 41 and the peel preventing bars 10 are provided on this polyimide film 91. This way the void sealed by the polyimide film 91 and the mount agent 8 can escape outside from the opening 41. In this embodiment, further, recesses 421 are formed in the opening 42 so that the recesses are exposed from the chip when the chip is mounted. The adhesion of the mold resin after mounting or resin sealing is further improved. The shape of the opening is not particularly restricted.

Although the shapes and sizes of the opening and peel preventing bars are not particularly restricted in this invention, it is important that the space defined by the chip and the bed be sufficiently filled with the mold resin, so that it is desirable that the peel preventing bars should be arranged not too much apart from one another and at equal intervals. In the seventh to tenth embodiments, the areas which require the half etching of the surfaces of the peel preventing bars are effective if located inward from the bed center by about 90% of the area of the bottom of the chip for the polyimide film and the chip adhesion position accuracy (area securing). The half etching of the peel preventing bars can of course be adapted for the first to sixth embodiments. The penetration preventing holes of the fifth embodiment can be adapted for any other embodiment where no dam is formed. Although the polyimide film is used as a dam against the mount agent, it may be used as an interval holding member for securing the space between the chip and the bed. In this case, the polyimide film can be arranged near the outer sides of the bed, not over or near the opening.

The material for a dam is not limited to the polyimide film, but an insulating film of other synthesized resins or inorganic material may be used and the mount agent may be combined to ensure the application which matches the characteristic of the chip. For example, an insulating mount agent such as epoxy resin may be combined with the polyimide film or a conductive mount agent such as silver paste may be combined with the polyimide film, allowing the semiconductor substrate to have the same conductive potential as the bed.

According to the present invention, peeling of the mold resin from the chip or the bed occurs locally and even if peeling becomes larger, pressure is generated in small sections, so that the occurrence of cracks can be suppressed even if peels 21, 22 of the mold resin 1 from the bottom of the chip 4 or the bed 62 occur under them.

The present invention with the above-described structures can prevent the occurrence of cracks when the IR reflow or VPS reflow is carried out while the resin-sealed semiconductor device has absorbed moisture. Since sufficient space can be secured between the bed and chip, the adhesion strength of the mold resin is improved.

## Claims

1. A semiconductor device characterized by comprising:

   a bed (62) having a substantially rectangular opening (41) at a center thereof;

   a plurality of peel preventing bars (10) arranged inside the opening;

   a semiconductor element (4) mounted on said bed, said semiconductor element covering said rectangular opening, peel preventing bars, and a peripheral portion of said rectangular opening of said bed;

   a mounting agent (8) formed on said peripheral portion for bonding said semiconductor element onto a surface of said bed, said mounting agent having a predetermined thickness; and

   a molding material (1) sealing said bed, said semiconductor element and said mounting agent, and filling a region between said peel preventing bars and said semiconductor element.

2. The semiconductor device according to claim 1, characterized in that said peel preventing bars comprising:

   a first bar arranged across the opening along a first direction; and

   a second bar arranged across the opening along a second direction.

3. The semiconductor device according to claim 2, characterized in that said first direction is perpendicular to said second direction.

4. The semiconductor device according to claim 1, characterized in that said peel preventing bars comprise a plurality of bars parallely arranged across the opening.

5. The semiconductor device according to claim 1, characterized in that said bed has a first edge of the opening and a second edge of the opening opposite said first edge, and said peel preventing bars comprise a plurality of first bars extending from the first edge toward the second edge and a plurality of second bars extending from the second edge toward the first edge.

6. The semiconductor device according to claim 1, characterized in that said rectangular opening has a first, a second, a third and a fourth corners, and said peel preventing bars comprise a first bar diagonally arranged between the first and the third corners and a second bar diagonally arranged between the second and the fourth corners.

7. The semiconductor device according to claim 1, characterized in that said peel preventing bars are arranged in a "#" shape.

8. The semiconductor device according to claim 1, characterized in that said peel preventing bars comprise a first, a second, a third and a fourth bars so interconnected to form a closed rectangular shape and a plurality of connecting bars for connecting said first, second, third and fourth bars to the bed.

9. The semiconductor device according to claim 1, characterized in that said peel preventing bars are arranged in a diamond grid form.

10. The semiconductor device according to claim 1, characterized in that said semiconductor element has a first surface facing said bed and a second surface opposite to the first surface, and a first thickness of a first portion of said molding material on said first surface of said semiconductor element is larger than a second thickness of a second portion of said molding material on said first surface of said semiconductor element.

11. The semiconductor device according to claim 10, characterized in that said second thickness is larger than a distance between said peel preventing bars and said semiconductor element.

12. The semiconductor device according to claim 1, characterized by further comprising means (9, 90, 91, 92) for preventing said mounting agent to penetrate on a surface of said peel preventing bars.

13. The semiconductor device according to claim 1, characterized by further comprising means (9, 90, 91) for keeping a distance between said peel preventing bars and said semiconductor element.

14. The semiconductor device according to claim 12, characterized in that said preventing means is a dam having the predetermined thickness.

15. The semiconductor device according to claim 12, characterized in that said preventing means is a dam formed on said bed, said dams being made of plating material.

16. The semiconductor device according to claim 15, characterized in that said plating material is Ag.

17. The semiconductor device according to claim 12, characterized in that said preventing means is a dam formed on said bed, said dams being made of a polyimide film.

18. The semiconductor device according to claim 12, characterized in that said preventing means is a dam formed on said peripheral portion, said dam surrounding said rectangular opening.

19. The semiconductor device according to claim 12, characterized in that said preventing means are dams each formed on an area where said peel preventing means is connected to the bed.

20. The semiconductor device according to claim 19, characterized in that a part of said dams are arranged to form a continuous strip.

21. The semiconductor device according to claim 12, characterized in that said preventing means are holes (92) each formed on an area where said peel preventing means is connected to the bed.

22. The semiconductor device according to claim 21, characterized in that each of said holes is substantially rectangular form, and a long side of each of said holes is larger than a width of each of said peel preventing bars.

23. The semiconductor device according to claim 12, characterized in that said preventing means are a plurality of narrow necked portions of said peel preventing bars.

24. The semiconductor device according to claim 1, characterized in that said peel preventing bars has a plurality of narrow necked portions for preventing said molding agent to penetrate on a surface of said peel preventing bars.

25. The semiconductor device according to claim 1, characterized in that a first thickness of said bed is larger than a second thickness of a center portion of said peel preventing bars.

26. The semiconductor device according to claim 1, characterized in that a center portion of said peel preventing bars is half-eched.

27. The semiconductor device according to claim 25, characterized by further comprising a dam (9, 90, 91) formed on said peel preventing bars, said dam surrounding said center portion of said peel preventing bars.

28. The semiconductor device according to claim 27, characterized in that said bed is recessed to expand said rectangular opening.

29. A method of fabricating a semiconductor device characterized by comprising the steps of:

preparing a bed (62) having an opening (41) and a plurality of peel preventing bars (10) arranged in said opening;

supplying a mounting agent (8) onto the bed at a peripheral portion surrounding said opening;

mounting a semiconductor element (4) on said bed with the mounting agent (8); and

sealing said bed, said mounting agent and said semiconductor element with a molding material (1).

30. The method of fabricating a semiconductor device according to claim 29, characterized by further comprising the step of:

forming a dam (9, 90, 91) on said bed at the peripheral portion, before supplying the mounting agent.

31. The method of fabricating a semiconductor device according to claim 29, characterized by further comprising the step of:

forming a plurality of holes (92) on areas where said peel preventing means are connected to the bed.

32. A method of fabricating a semiconductor device characterized by comprising the steps of:

preparing a bed (62) having an opening (41) and a plurality of peel preventing bars (10) arranged in said opening, a center (102) of said peel preventing bars being half-etched;

supplying a mounting agent (8) onto the bed at a peripheral portion surrounding said opening;

mounting a semiconductor element (4) on said bed with the mounting agent; and

sealing said bed, said mounting agent and said semiconductor element with a molding material (1).

33. The method of fabricating a semiconductor device characterized by comprising the step of:

forming a dam (9, 90, 91) on said bed around the center portion, before supplying the mounting agent.

34. A method of fabricating a semiconductor device characterized by comprising the steps of:

preparing a bed (62) having an opening (41) and a plurality of peel preventing bars (10) arranged in said opening, said peel preventing bars having a plurality of narrow necked portions (101);

supplying a mounting agent (8) onto the bed at a peripheral portion surrounding said opening;

mounting a semiconductor element (4) on said bed with the mounting agent; and

sealing said bed, said mounting agent and said semiconductor element with a molding material (1).

35. A resin-sealed semiconductor device characterized by comprising:

a semiconductor element (4);

a semiconductor element mounting portion (62) where said semiconductor element is to be mounted and which has an opening;

leads (2) arranged apart from one another around said semiconductor element mounting portion;

a mounting agent (8) for bonding said semiconductor element to said semiconductor element mounting portion;

bonding wires (3) for connecting connection electrodes (7), formed on a surface of said semiconductor element, to said leads; and

a mold resin (1) for covering said semiconductor element, said semiconductor element mounting portion, said mounting agent, said bonding wires and portions of said leads,

said opening of said semiconductor element mounting portion having a plurality of peel preventing bars (10) for preventing said mold resin from peeling from a back of said semiconductor element, said mold resin filling space between said peel preventing bars and said semiconductor element mounting portion.

36. The resin-sealed semiconductor device according to claim 35, characterized in that inhibiting means (9, 90, 91, 92) for inhibiting said mount agent from flowing over said peel preventing bars is formed around said opening of said semiconductor element mounting portion.

37. The resin-sealed semiconductor device according to any one of claims 1; 2, 35 or 36, characterized in that at least some of said plurality of peel preventing bars (10) are connected to an inner periphery of said opening, and a portion (102) of said peel preventing bar to be connected to the inner periphery of said opening is thinner than the other portion.

**38.** The resin-sealed semiconductor device according to any one of claims 1, 2, 3, 35, 36 or 37, characterized in that said peel preventing bars are made thinner than said semiconductor element mounting portion so that a distance between a bottom of said semiconductor element and said peel preventing bars is greater than a distance between said bottom of said semiconductor element and a surface of said semiconductor element mounting portion.

**39.** The resin-sealed semiconductor device according to any one of claims 1, 2, 3, 4, 35, 36, 37 or 38, characterized in that said opening is covered with said semiconductor element to be connected to said semiconductor element mounting portion, and at least one recess or through hole is formed around said opening, at least a portion of said recess or through hole being not covered with said chip.

**40.** A method of fabricating a resin-sealed semiconductor device characterized by comprising the steps of:
  providing a plurality of peel preventing bars (10) at an opening (41) formed in a center portion of a semiconductor element mounting portion (62);
  supplying a mounting agent (8) to said semiconductor element mounting portion from a plurality of nozzles;
  placing a semiconductor element (4) on said semiconductor element mounting portion and pressing said semiconductor element to adhere said semiconductor element to said semiconductor element mounting portion;
  arranging leads (2) apart from one another around said semiconductor element mounting portion;
  electrically connecting connection electrodes (7), formed on a surface of said semiconductor element, to said leads with bonding wires (3); and
  covering said semiconductor element, said semiconductor element mounting portion, said mounting agent, said bonding wires and portions of said leads with a mold resin (1),
  whereby at a time of supplying said mount agent from said nozzles, supply positions of said mount agent are adjusted in such a way that when said semiconductor element is placed on and pressed against said semiconductor element mounting portion, said mount agent does not flow over said peel preventing bars formed at said opening.

F I G. 1

F I G. 2

F I G. 3

F I G. 4A

F I G. 4B

F I G. 5A

F I G. 5B

F I G. 6A

F I G. 6B

F I G. 7

F I G. 8

F I G. 9

F I G. 10

F I G. 11

FIG. 12

FIG. 13A

FIG. 13B

FIG. 13C

F I G. 14A

F I G. 14B

F I G. 15A

F I G. 15B

F I G. 16A

F I G. 16B

F I G. 17A

F I G. 17B

F I G. 18A

F I G. 18B

23

F I G. 19A

F I G. 19B

F I G. 20

F I G. 21A

F I G. 21B

FIG. 22A

FIG. 22B

FIG. 23A

FIG. 23B

F I G. 24A

F I G. 24B

F I G. 25A

F I G. 25B

F I G. 26A

F I G. 26B

F I G. 27A

F I G. 27B

F I G. 27C

F I G. 28A

F I G. 28B

F I G. 29

F I G. 30A

F I G. 30B

FIG. 31

FIG. 32A

FIG. 32B

FIG. 33

FIG. 34A

FIG. 34B

FIG. 35